Europäisches Patentamt

European Patent Office

Office européen des brevets

(19)

(11) Publication number: **0 039 219**
**B1**

(12) **EUROPEAN PATENT SPECIFICATION**

(45) Date of publication of patent specification: **19.12.84**

(21) Application number: **81301819.9**

(22) Date of filing: **24.04.81**

(51) Int. Cl.³: **H 01 J 29/45**

(54) **Light sensitive screen and devices including the same.**

(30) Priority: **25.04.80 JP 54155/80**

(43) Date of publication of application:
**04.11.81 Bulletin 81/44**

(45) Publication of the grant of the patent:
**19.12.84 Bulletin 84/51**

(84) Designated Contracting States:
**DE FR GB NL**

(56) References cited:
**DE-A-1 762 202**
**GB-A-1 349 351**
**GB-A-1 460 339**
**GB-A-1 483 499**
**GB-A-2 029 642**
**US-A-3 890 524**
**US-A-4 128 844**
**US-A-4 147 667**

(73) Proprietor: **Hitachi, Ltd.**
**5-1, Marunouchi 1-chome**
**Chiyoda-ku Tokyo 100 (JP)**

(72) Inventor: **Ishioka, Sachio**
**1-49-23 Zoushigaya**
**Toshima-ku Tokyo (JP)**
Inventor: **Imamura, Yoshinori**
**2-32-C207 Koyasu-cho**
**Hachioji-shi, Tokyo (JP)**
Inventor: **Shimomoto, Yasuharu**
**2196-92 Hirai Hinodemachi**
**Nishitama-gun Tokyo (JP)**
Inventor: **Ataka, Saburo**
**2196-195 Hirai Hinodemachi**
**Nishitama-gun Tokyo (JP)**
Inventor: **Tanaka, Yasuo**
**1-217 Higashi-koigakubo**
**Kokubunji-shi Tokyo (JP)**
Inventor: **Maruyama, Eiichi**
**1572-3 Josuihoncho**
**Kodaira-shi Tokyo (JP)**

(74) Representative: **Paget, Hugh Charles Edward**
**et al**
**MEWBURN ELLIS & CO. 2/3 Cursitor Street**
**London EC4A 1BQ (GB)**

Courier Press, Leamington Spa, England.

## Description

This invention relates to a light sensitive screen which employs as its photoelectric material an amorphous silicon film containing hydrogen, and devices including such a screen.

Such a light sensitive screen is especially useful when applied to a photosensor which is operated in the storage mode, for example, a target for a photoconductive type image pick up tube or a solid-state imaging device.

We use the term "screen" here to mean a member or element having a photoconductive layer of any shape suitable for the particular intended use.

Amorphous silicon containing hydrogen has photoconductivity and can form a thin film of large area at a comparatively low temperature, so that it has been proposed to use it in the light sensitive screens of solar cells, imaging devices etc. A typical example of a photosensor operated in the storage mode, is the photoconductive type image pickup tube.

For example, US—A—4,255,686 proposes the use, as the photoconductive layer of such an image pick-up tube, of an amorphous material whose principal constituent is silicon and which contains hydrogen.

GB—A—2,029,642 is concerned with the application of hydrogen-containing amorphous silicon to a solid-state imaging device which employs a photoconductor. It discloses a light sensitive screen with a light transmitting film and a photoconductive layer formed of amorphous silicon containing hydrogen, the light transmitting film being on the side of the photoconductive layer to which light is intended to be incident. The photoconductive layer preferably contains at least 5 atomic-% and less than 30 atomic-% of hydrogen. Therefore UK—A—2,029,642 corresponds to the pre-characterising portion of claim 1.

Hydrogen-containing amorphous silicon can readily provide a high resistivity. This is an advantage not inherent in materials previously used for light sensitive screens, for example, $Sb_2S_3$-, PbO- and Se-based chalcogenide glasses. It means that a charge pattern stored on the side of a light sensitive screen which is scanned by an electron beam does not decay within the necessary storage time (the period of scanning of a specified picture element by the scanning electron beam).

The following publications also form part of the prior art:—

    (1) GB—A—1,349,351
    (2) US—A—4,147,667

The present invention seeks to provide a light sensitive screen with improved characteristics. It has been found that for a given hydrogen concentration amorphous silicon has two forbidden band gaps, and that one of these band gaps is particularly advantageous in the operation of a light sensitive screen. Therefore the present invention proposes that the photoconductive layer of the light sensitive screen has an optical forbidden band gap in the range 1.65 eV to 2.25 eV and an infrared absorption spectrum in which the peak at the wave number 2,100 $cm^{-1}$ is not smaller than that at the wave number 2,000 $cm^{-1}$. It has been found that such a light sensitive screen has a very good characteristic e.g. as a screen for an imaging device.

The optical forbidden band gap is preferably 1.85 eV—2.10 eV.

Particularly favourable characteristics are obtained when the IR absorption peak component at the wave number 2,000 $cm^{-1}$ is not greater than 80% of that at the wave number 2,100 $cm^{-1}$. It is even more preferable that the former component is not greater than 50% of the latter, and most preferred that the former is not greater than 25% of the latter.

It is important that the hydrogen content of the amorphous silicon is 5 atomic-% to 30 atomic-%. More preferably, the hydrogen content is 7 atomic-% to 20 atomic-%. If the hydrogen content is too low or if it is too high, the photoconductivity characteristics deteriorate sharply.

As compared with previously known light sensitive screens which employ hydrogen-containing amorphous silicon as their photoelectric material, the screen of this invention can excel in the various characteristics mentioned below (all these characteristics are important in imaging devices):—

    (1) dark current

    (2) lag

    (3) after image

    (4) resolution

Practical comparisons will be discussed later.

Embodiments of the invention will now be described below by way of example with reference to the accompanying drawings, in which:—

Figure 1 is a graph showing the infrared absorption spectral curves of hydrogen-containing amorphous silicon,

Figure 2 is an explanatory view of a sputtering apparatus.

Figure 3 is a schematic sectional view of a photoconductive type image pickup tube,

Figures 4 to 10 are sectional views of targets for image pickup tubes,

Figure 11 is a diagram explaining the principle of a solid-state imaging device, and

Figures 12 and 13 are sectional views of a solid-state imaging device showing manufacturing steps thereof.

The optical forbidden band gap of amorphous silicon depends upon the composition and structure of the material, particularly upon the hydrogen content thereof. However, for any particular hydrogen content, the optical forbidden band gap assumes two states. Examples are listed in Table 1.

TABLE 1

| No. | Hydrogen content (atomic-%) | Optical forbidden band gap (eV) | |
|---|---|---|---|
| | | First state | Second state (this invention) |
| 1 | 5 | 1.3 | 2.3 |
| 2 | 10 | 1.45 | 2.0 |
| 3 | 15 | 1.55 | 1.95 |
| 4 | 20 | 1.60 | 1.90 |

The reason why such two states develop has not been fully explained.

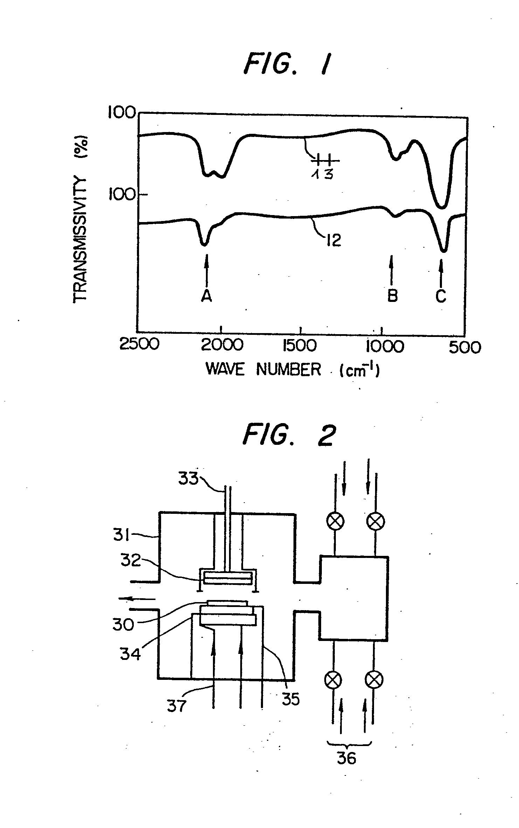

Figure 1 shows the infrared absorption spectral curves of hydrogen-containing amorphous silicon. The peaks of an infrared absorption spectrum which are observed include (1) one caused by the stretching vibration mode of the coupling between hydrogen and silicon, (2) one caused by the bending vibration mode thereof, and (3) one caused by the wagging or rocking vibration mode thereof. In Figure 1, these peaks correspond to peaks at positions A, B, and C respectively. Also the stretching vibration mode causes divided peaks in the vicinity of wave number 2,000 cm$^{-1}$ and in the vicinity of wave number 2,100 cm$^{-1}$. Curve 13 shows an example in which both these peaks have approximately equal magnitudes, whilst the curve 12 shows an example in which the peak at the wave number 2,100 cm$^{-1}$ is greater than the peak at the wave number 2,000 cm$^{-1}$.

These peaks correspond to different hydrogen-silicon coupling states. It has been found that hydrogen-containing amorphous silicon in which the component at the wave number 2,100 cm$^{-1}$ is greater than the component at the wave number 2,000 cm$^{-1}$ is very favourable for imaging devices.

Table 2 lists measured results of the ratios of these infrared adsorption peaks and the various characteristics of imaging devices made from the corresponding materials.

TABLE 2

| (peak) 2,000/(peak) 2,100 | at least 1 (one) | 0.8 | 0.5 | 0.25 |
|---|---|---|---|---|
| photocurrent (nA) (10 1× illumination) | 800 | 600 | 800 | 900 |
| dark current | 100 | 10 | 3 | 1 |
| lag (%, after 50 sec) | 80 | 20 | 15 | 10 |
| after image | above 1 min | 15 sec | below 1 sec | below 1 sec |
| thickness of film ($\mu$m) | 2 | 2 | 2 | 2 |
| hydrogen content (atomic-%) | 7 | 20 | 15 | 10 |
| optical forbidden band gap (eV) | 1.6 | 1.85 | 1.9 | 2.1 |
| | comparative ex. | | | |

Although theory that would provide a reason why such differences in the characteristics arise has not been fully developed, we suggest the following as a possible explanation, based on present understanding. In amorphous silicon, hydrogen couples with the dangling bonds of silicon and reduces localized states in a forbidden band gap. The difference between the coupling states will result in different conditions for the localized states, and this will be an important factor in the development of these characteristics.

In addition, the photoconductive layer for use in an imaging device, preferably has a resistivity of at least $10^{10}$ $\Omega$. cm to prevent diffusion and disappearance of a charge pattern within the storage time. The photoconductive material of the present invention meets also this requirement satisfactorily.

A typical process for manufacturing the hydrogen-containing silicon according to the present invention is by reactive sputtering of silicon in an atmosphere which contains hydrogen. To obtain a high-resistivity sample, it is preferable to use a method which is based on the reactive sputtering of a silicon alloy in a mixed atmosphere consisting of hydrogen and a rear gas such as argon.

Figure 2 shows an example of the sputtering process. A sample 30 is placed in a vessel 31 which can be evacuated to vacuum, and a sputtering target 32 for which a sintered compact of silicon or the like is used is located adjacent the sample 30. An r.f. voltage is applied to an electrode 33. Also shown are a sample holder 34, a thermocouple for measuring the temperature 35, gas inlets 36 for a rare gas such as argon and hydrogen etc., and a passage 37 for cooling water.

A low-temperature and high-speed sputtering apparatus of the magnetron type provides a suitable sputtering apparatus. Usually, when an amorphous film containing hydrogen and silicon is heated to or above 350°C, it emits hydrogen and changes in quality. Therefore, the substrate temperature during the formation of the film should preferably be held between 100°C and 300°C, more preferably between 200°C and 250°C. The pressure of the atmosphere during the sputtering discharge reaction is set at $6.7 \times 10^{-2}$ to 1.3 Pa ($5 \times 10^{-4}$ Torr to $1 \times 10^{-2}$ Torr). The partial pressure of hydrogen is set at 20% or above, preferably 40% or above.

The hydrogen content of the amorphous silicon depends upon the partial pressure of hydrogen in the atmosphere, and it is desirable that there is at least 0.13 Pa ($1 \times 10^{-3}$ Torr) of hydrogen.

In manufacturing a light sensitive screen according to the present invention scrupulous care must be taken about impure gases in the atmosphere during the sputtering, as will now be explained.

Of the impurities in the atmosphere within the sputtering device, oxygen should be at most $6.7 \times 10^{-3}$ Pa ($5 \times 10^{-5}$ Torr), nitrogen at most $1.3 \times 10^{-3}$ Pa ($1 \times 10^{-5}$ Torr) and water at most $1.3 \times 10^{-3}$ Pa ($1 \times 10^{-5}$ Torr). The co-existence of oxygen and water is a particular obstacle to the formation of the hydrogen-containing amorphous silicon used in the light sensitive screen of the present invention.

The sputtering input may be either direct-current (D.C.) discharge or radio-frequency discharge. If D.C. discharge is used, the power density is set between 0.6 and 6.0 W/cm², and in order to attain sufficient power, it is recommended to adjust the input power to between 100 W and 1 kW and the voltage to between 0.8 and 1.5 kV. For the radio-frequency discharge, the frequency is usually set between 0.2 and 30 MHz, and the power density is usually set between 0.6 and 6.0 W/cm², preferably

4

between 1.0 and 3.0 W/cm². In order to attain sufficient power, it is recommended to adjust the voltage to 0.8 to 1.5 kV. For magnetron type radio-frequency discharge, the power density is set between 0.6 and 6.0 W/cm², preferably between 1.0 and 3.0 W/cm², and the voltage is generally adjusted to between 0.2 and 0.5 kV in order to attain sufficient power.

The growth rate of the amorphous silicon film is usually set between 0.05 and 8 nm/s, preferably between 0.1 and 2 nm/s.

The thickness of the photoconductive layer of the light sensitive screen of this invention is usually made approximately 0.1 $\mu$m to 50 $\mu$m. In imaging devices, this thickness is preferably made approximately 1 to 10 $\mu$m.

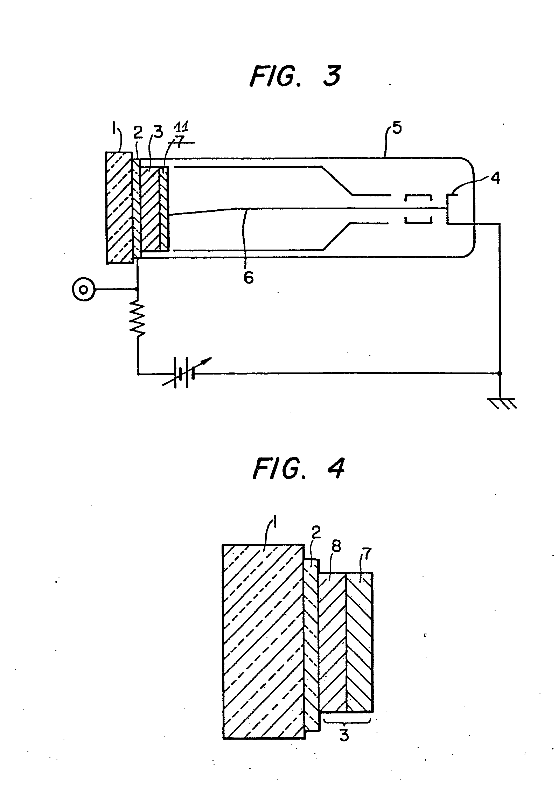

A typical example of a photosensor which is used in the storage mode is the photoconductive type image pickup tube. Figure 3 shows a sectional view of such a device to explain the principles of operation thereof. The device consists of a light-transmitting substrate 1 usually called "faceplate", a transparent conductive film 2, a photoconductive layer 3, an electron gun 4, and an envelope 5. An optical image focused on the photoconductive layer 3 through the face plate 1 is photoelectrically converted and is stored as a charge pattern in the surface of the photoconductive layer 3. The charge pattern is read in time sequence by a scanning electron beam 6.

A beam landing layer 11 is usually disposed on the surface of the photoconductive layer 3 *inter alia* for preventing inversion and for checking the injection of electrons from the scanning electron beam.

The photoconductive layer of the light sensitive screen may be formed in a plurality of layers. Figure 4 is a sectional view showing such an example. Transparent conductive film 2 is formed on a light transmitting substrate 1, and a photoconductive layer 3 formed by two photoconductive films 7, 8 is formed on the transparent conductive film 2. In this case, the photoconductive film 8 should preferably be made of hydrogen-containing amorphous silicon having properties to be discussed below. This is because these properties enhance the bonding between the substrate 1 and the photoconductive layer 3.

The characteristics of the hydrogen-containing amorphous silicon are that (1) hydrogen is present at a content of at least 5 atomic-%—30 atomic-% and (2) in the observed infrared adsorption peaks, the component corresponding to the wave number 2,100 cm$^{-1}$ is observed to be smaller than the component corresponding to the wave number 2,000 cm$^{-1}$. (3) The thickness of the film 8 is between 0.01 $\mu$m and 30 $\mu$m, preferably between 0.05 and 1 $\mu$m.

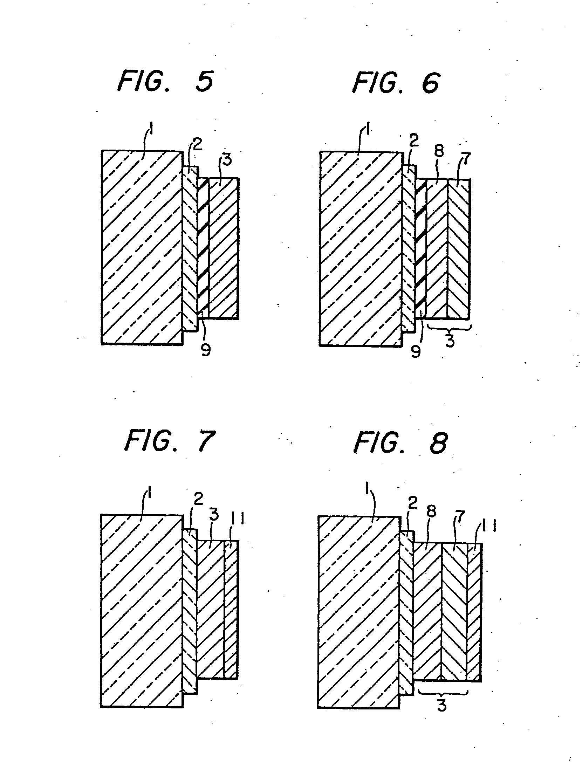

A low resistivity oxide film of $SnO_2$, $In_2O_3$, $TiO_2$ or the like or a semitransparent metal film of Al, Au or the like can usually be used to form the transparent conductive film 2. In order to reduce the dark current of the photosensor and to raise the response rate, it is desirable to form a rectifying contact between the transparent conductive film 2 and the photoconductive layer 3. In addition, the injection of holes from the transparent conductive film 2 into the photoconductive layer 3 can be suppressed by interposing a thin, hole blocking layer between the photoconductive layer 3 and the transparent conductive film 2. Thus, a good rectifying contact may be obtained. In this case, in order to use the contact as a photodiode, it is desirable that the transparent conductive film is used as an anode and the amorphous layer is used as a cathode. Figure 5 shows an example of a photosensor having such structure. A hole blocking layer 9 is interposed between the transparent conductive film 2 and the amorphous photoconductor layer 3. Figure 6 is a sectional view showing an example of a photosensor which also has a hole blocking layer 9. This example is the same as the example of Figure 5 except that the photoconductive layer 3 has a laminated structure consisting of layers 7 and 8. Usually, a photoconductor which has sensitivity in the visible region is a semiconductor whose forbidden band gap is 2.0 eV or so. Thus the hole blocking layer 9 preferably has a forbidden band gap of at least 2.0 eV so as not to hinder the arrival of light at the photoconductive layer 3. The following materials are preferable for this:

(1) Oxide:
Oxide of at least one element selected from the group consisting of Si, Ti, Al, Mg, Ba, Ta, W, Bi, V, Ge, Ni, Th, Mo, Fe, La, Be, Sc and Co.
Examples are as follows: $SiO_2$, $TiO_2$, $Al_2O_3$, MgO, BaO, $Ta_2O_5$, $WO_3$, $Bi_2O_3$, $V_2O_5$, GeO, NiO, $ThO_2$, $Fe_2O_3$, $La_2O_3$, $MoO_3$, BeO, $Sc_2O_3$, $Co_2O_3$, and eutectics.

(2) Nitride:
Nitride of at least one element selected from the group consisting of Ga, Si, Mg, Ta, Hf, Zr, Nb and B.
Examples are as follows: GaN, $Si_3N_4$, $Si_2N_3$, $MgN_2$ TaN, HfN, ZrN, NbN, BN and eutectics.

(3) Halide:
Halide of at least one element selected from the group consisting of Na, Mg, Li, Ba, Ca and K.
Examples are MgF, LiF, NaF, $BaF_2$, $CaF_2$, KF and eutectics.
In addition, a layer of a mixture of two or more of the above-mentioned materials or stacked layers of the above-mentioned materials can be employed.

The layer is made approximately 5 to 500 nm thick. At a thickness of 100 nm or less, the transmission factor for incident light decreases by only a small amount, and hence there is no risk of lowering of the sensitivity of the photoelectric device.

Normally it is very favorable for the oxide layer stated above to be formed by a sputtering evaporation process by the use of the same oxide as the evaporation source material.

Sputtering evaporation usually employs radio-frequency discharge in Ar gas under a pressure of 13 to 0.13 Pa ($1 \times 10^{-1}$ Torr to $1 \times 10^{-3}$ Torr). If the oxide is liable to blacken due to reduction at this time, not more than approximately 5 volume-% of oxygen may be mixed into the Ar gas.

The temperature of the substrate during the evaporation may be 25°C to 400°C, but a value of 100°C to 250°C is preferable for forming a film which lies in close contact with the substrate and which has good flatness.

A thin layer of any of the above-mentioned oxides, nitrides and halides intervenes between the photoconductive film and the signal electrode. However, the thin layer need not necessarily adjoin the signal electrode, but a layer made of another material may intervene between the signal electrode and the thin layer. It is necessary, however, for the photoconductive film and the oxide to adjoin each other.

The hole blocking layer 9 can be used, not only for the light sensitive screen of the image pickup tube described before, but also for solid-state imaging device for similar purposes.

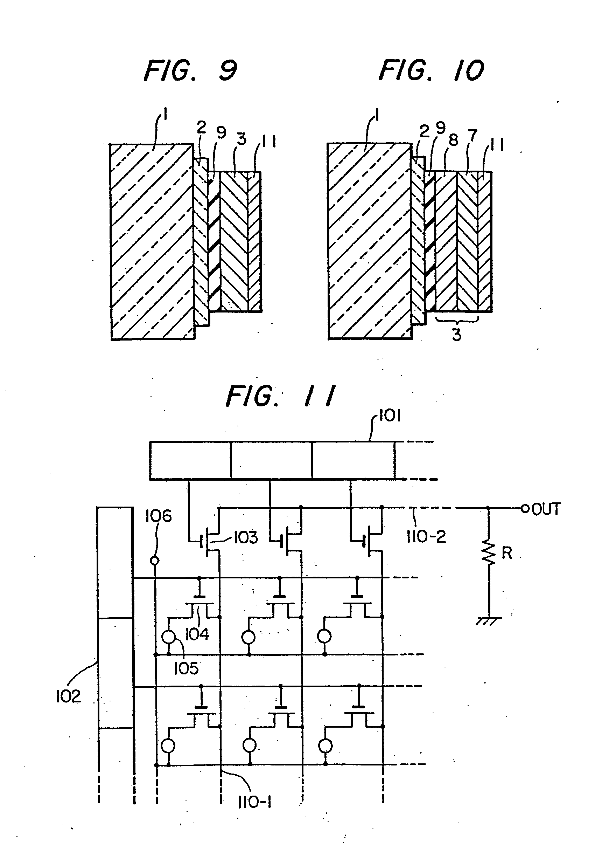

When employing a photoconductive layer with the characteristics required by the present invention as the target of an image pickup tube, it is desirable that a beam landing layer 11 such as antimony trisulphide is stacked on the surface of the photoconductive layer 3 so as to prevent the injection of electrons from the scanning electron beam 6 or to suppress the generation of secondary electrons from the photoconductive layer 3. To achieve this an antimony trisulphide film is evaporated in argon gas under a low pressure of 0.13 to 1.3 Pa ($1 \times 10^{-3}$ to $1 \times 10^{-2}$ Torr) and it is satisfactory if the thickness of the film lies between 10 nm and 1 $\mu$m. Figure 7 is a sectional view showing an example of this structure. A light transmitting substrate 1 is overlaid with a transparent conductive film 2 and a photoconductive film 3, on which an antimony trisulphide film 11 is also formed. Also Figures 8 to 10 are sectional views each showing an example in which the antimony trisulphide film 11 is formed on the photoconductive film 3. Figure 8 shows an example in which the photoconductive film 3 has a laminated structure consisting of layers 7 and 8, and Figures 9 and 10 show examples in which this feature is applied to a structure having a hole blocking layer 9 between the photoconductive film 3 and the transparent conductive film 2.

Although the photoconductive layer 3 has been exemplified only by a single layer and by two layers 7 and 8 in the above description it is possible to construct a suitable photoconductive layer consisting of more layers. It is also possible to vary the composition continuously within the layer.

The particular construction of the light sensitive screen thus far described may be selected according to the desired use.

Example 1

Both surfaces of a glass substrate having a diameter of 2.5 cm (1 inch) were optically polished, and a transparent conductive film of, for example, tin oxide ($SnO_2$) was disposed on one surface of the glass substrate to a thickness of 300 nm. Subsequently, a sintered compact of silicon with a purity of 99.999% was installed as a target in a radio-frequency sputtering apparatus. The glass substrate was mounted in the sputtering apparatus so that the target and the transparent conductive film opposed each other. At the next step, the vacuum vessel of the radio-frequency sputtering apparatus was evacuated to a high vacuum of approximately $6.7 \times 10^{-4}$ Pa ($5 \times 10^{-6}$ Torr) whereupon a gas consisting of a mixture of hydrogen and argon was introduced into the apparatus to a pressure of 1.3 to 0.13 Pa ($10^{-2}$ to $10^{-3}$ Torr).

A radio-frequency power of approximately 300 W (at 13.56 MHz) was applied to the target at a power density of 2 W/cm$^2$ with the temperature of the substrate held at approximately 200°C. In this case, the gas at sputtering had the following residual components:

| | |
|---|---|
| oxygen | $1.3 \times 10^{-3}$ Pa ($1 \times 10^{-5}$ Torr) |
| nitrogen | $1.3 \times 10^{-3}$ Pa ($1 \times 10^{-5}$ Torr) |
| water | $6.7 \times 10^{-4}$ Pa ($5 \times 10^{-6}$ Torr) |

Discharge was established across the target and the substrate, and hydrogen-containing amorphous silicon was deposited on the glass substrate. Table 3 lists samples manufactured and the main properties and manufacturing conditions thereof. Run No. 1 is a comparative example.

TABLE 3

| Run No. | Hydrogen content (atomic-%) | Optical forbidden band gap (eV) | (Peak) 2,000/ (peak) 2,100 |
|---|---|---|---|
| 1 | 1 | 1.1 | 3.0 |
| 2 | 5 | 2.3 | 1.0 |
| 3 | 7 | 2.32 | 0.8 |
| 4 | 10 | 2.0 | 0.3 |
| 5 | 15 | 1.95 | 0.2 |
| 6 | 20 | 1.90 | 0.1 |
| 7 | 25 | 1.80 | 0.1 |
| 8 | 30 | 1.70 | 0.1 |

TABLE 3 (Continued)

| Run No. | Gaseous pressure Pa (Torr) | Partial pressure of hydrogen Pa (Torr) | Substrate temperature (°C) | Lag (%) | After image |
|---|---|---|---|---|---|
| 1 | 0.67 $(5 \times 10)^{-3}$ | $1.3 \times 10^{-3}$ $(1 \times 10^{-5})$ | 250°C | 30 | below 1 min |
| 2 | " | $2.7 \times 10^{-2}$ $(2 \times 10^{-4})$ | 250°C | 14 | below 15 sec |
| 3 | " | $5.3 \times 10^{-2}$ $(4 \times 10^{-4})$ | 250°C | 11 | below 1 sec |
| 4 | " | $6.7 \times 10^{-2}$ $(5 \times 10^{-4})$ | 250°C | 10 | below 1 sec |
| 5 | " | $0.4$ $(3 \times 10^{-3})$ | 250°C | 10 | below 1 sec |
| 6 | " | $0.27$ $(2 \times 10^{-3})$ | 250°C | 10 | below 1 sec |
| 7 | " | $0.13$ $(1 \times 10^{-3})$ | 100°C | 14 | below 15 sec |
| 8 | " | $0.13$ $(1 \times 10^{-3})$ | 100°C | 18 | below 15 sec |

Antimony trisulfide was evaporated onto each of the samples mentioned above to form a beam landing layer with a thickness of 100 nm. The evaporation of the antimony trisulfide was carried out in argon gas under a pressure of 0.13 Pa ($1 \times 10^{-3}$ Torr).

The light sensitive screen thus fabricated (for example, sample No. 6 in Table 3) was assembled into a vidicon type image pickup tube, and its characteristics were measured. Under illumination of white light of 10 1x and an applied voltage of 30 V, favourable characteristics were obtained, such as a photo signal current of 900 A and a dark current of below 1 nA. The other light sensitive screens were also sufficiently useful as imaging devices.

Example 2

As shown in Figure 9, a transparent conductive film 2 made of $SnO_2$ was formed on a glass substrate 1. The resultant substrate was installed on a substrate holder electrode in a radio-frequency sputtering apparatus. An $SiO_2$ target was installed on a target electrode. Subsequently, the sputtering chamber of the apparatus was evacuated to a pressure of less than $6.7 \times 10^{-4}$ Pa ($5 \times 10^{-6}$ Torr) whereupon Ar gas was introduced thereinto so as to establish a gas pressure of 0.67 Pa ($5 \times 10^{-3}$ Torr).

Radio-frequency discharge at an output of 1.5 W/cm$^2$ at 13.56 MHz was applied across both the electrodes under the previously mentioned gas pressure, to form an $SiO_2$ thin film to a thickness of approximately 25 nm forming a hole blocking layer 9 on the transparent conductive layer 2.

Subsequently a sintered compact of silicon at 99.999% was mounted on the target electrode of the radio-frequency sputtering apparatus. An amorphous silicon film 3 was formed on the $SiO_2$ thin film 9 by reactive sputtering in a mixed atmosphere consisting of 0.13 Pa ($1 \times 10^{-3}$ Torr) of Ar and 0.27 Pa ($2 \times 10^{-3}$ Torr) of hydrogen. At this time, the partial pressures of the remaining gases were the same as in Example 1. The substrate was held at 200°C. The amorphous silicon film thus formed contained approximately 10 atomic-% of hydrogen and had a resistivity of $10^{14}$ $\Omega$ . cm.

The optical forbidden band gap of the amorphous silicon film was 2.0 eV, and the ratio between the peaks of an infrared absorption spectrum, i.e. (peak) 2,000/(peak) 2,100 was 0.2.

The $SiO_2$ thin film 9 can be formed by electron-beam evaporation as an alternative to the sputtering process described above. An $SiO_2$ film formed by electron-beam evaporation exhibits a dark current suppressing effect approximately equal to that of a film formed by a sputtering process. In general, however, an evaporated film has inferior bonding strength to the substrate, as compared with a sputtering film, and it can exfoliate from the substrate when the amorphous silicon is deposited thereon.

Lastly, an $Sb_2S_3$ film 11 was evaporated in an Ar gas pressure to a thickness of approximately 100 nm to form a beam landing layer for improving the landing characteristics of an electron beam.

With the pickup tube target fabricated by the above method, the dark current was suppressed so that it was sufficiently low even at a high target voltage.

The various materials previously mentioned for forming the hole block layer were studied. Principal materials are summarised in Table 4. In the table, they are sorted into three classes in accordance with their effects on the dark current.

TABLE 4

| characteristics Material | Dark current (target voltage $V_T$=50 V) (relative value) | | |
|---|---|---|---|
| | 1 | 1—2 | 2—10 |
| Oxide | $SiO_2$, BaO, $Ta_2O_5$, $TiO_2$, $Al_2O_3$ | MgO, $WO_3$, $V_2O_5$, NiO, $Fe_2O_3$, $MoO_3$, $CoO_3$ | $Bi_2O_3$, GeO, $ThO_2$, $La_2O_3$, BeO, $ScO_3$ |
| Nitride | $Si_3N_4$, TaN | GaN, $Si_2N_3$, $MgN_2$ | HfN, ZrN, NbN, BN |
| Halide | LiF, $MgF_2$ | $BaF_2$, $CaF_2$, NaF, KF | |

$SiO_2$, BaO, $TiO_2$, $Ta_2O_5$ and $Al_2O_3$ among oxides, $Si_3N_4$ and TaN among nitrides and LiF and $MgF_2$ among halides produce extraordinarily good characteristics. Also, MgO, $WO_3$, $V_2O_5$, NiO, $Fe_2O_3$, $MoO_3$ and $Co_2O_3$ among oxides, GaN, $Si_2N_3$, and $MgN_2$ among nitrides and $BaF_2$, $CaF_2$, NaF and KF among halides, produce good characteristics.

Example 3

This example will be described with reference to Figure 10.

A transparent conductive film 2 made of $SnO_2$ was formed on a glass substrate 1, and the resultant substrate was installed in a radio-frequency sputtering apparatus. An $SiO_2$ target was installed on a target electrode. Subsequently, the sputtering chamber of the apparatus was evacuated to a pressure of less than $6.7 \times 10^{-4}$ Pa ($5 \times 10^{-6}$ Torr) whereupon Ar gas was introduced thereinto so as to establish a gas pressure of 1.3 Pa ($1.0 \times 10^{-2}$ Torr).

Radio-frequency discharge at a frequency of 13.56 MHz and an output of 1 W/cm$^2$ was applied across the electrodes, to form an $SiO_2$ thin film as a hole blocking layer 9 on the transparent electrode 2 to a thickness of approximately 25 nm.

Subsequently, a sintered compact of silicon at 99.999% was mounted on the target electrode of the radio-frequency sputtering apparatus. An amorphous silicon film 8 was formed in a mixed atmosphere consisting of 0.13 Pa ($1 \times 10^{-3}$ Torr) of argon and $2.7 \times 10^{-2}$ Pa ($2 \times 10^{-4}$ Torr) of hydrogen, and an amorphous silicon film 7 in a mixed atmosphere consisting of 0.13 Pa ($1 \times 10^{-3}$ Torr) of argon and $2.7 \times 10^{-1}$ Pa ($2 \times 10^{-3}$ Torr) of hydrogen, in both cases by reactive sputtering. Residual gas components at the formation of the amorphous silicon film 7 were approximately the same as in Example 1.

The properties of the amorphous silicon films 7 and 8 where as follows. The hydrogen content of the film 8 was 5 atomic-%, the optical band gap was 1.7 eV, and the ratio (peak) 2,000/(peak)

O 039 219

2,100=2.0. The hydrogen content of the film 7 was 15 atomic-%, the optical band gap was 2.0 eV, and the ratio (peak) 2,000/(peak) 2,100=0.5.

An antimony trisulphide layer 11 was formed on the photoconductive layer 3, to complete a target of a vidicon type image pickup tube.

When the film 8 was formed in this manner, surface defects due to the film exfoliation decreased, and a picture in which no flaw was noted was obtained at an applied voltage of 30 V.

Example 4

This embodiment is an example in which the present invention is applied to the light sensitive screen of a solid-state imaging device.

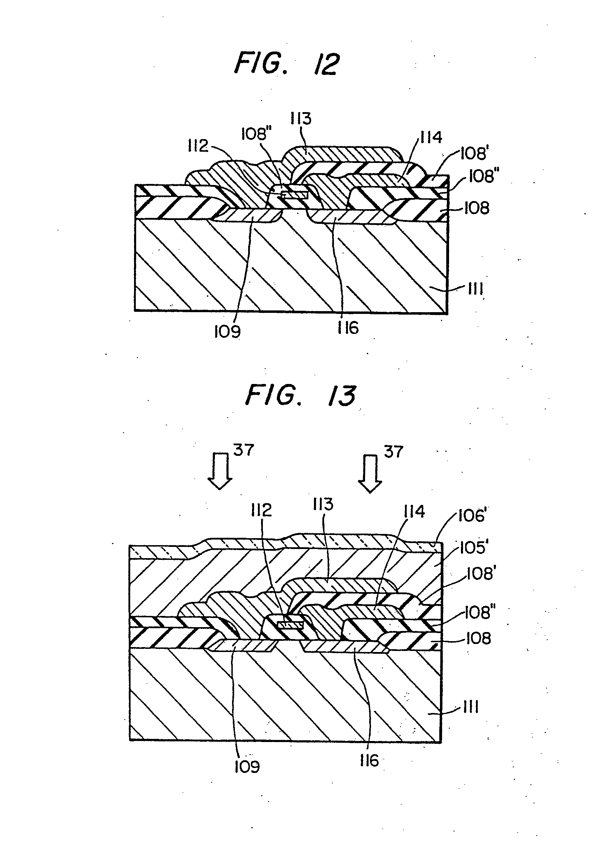

As an example of the solid-state imaging device, scanning circuits and groups of switches connected therewith are arrayed on a semiconductor substrate and are overlaid with a photoconductive thin film for photoelectric conversion. Owing to the double-layer structure in which photoelectric elements are formed on the scanning circuits as well as the groups of switches, the density of integration of picture elements (in other words, resolution) and the light receiving efficiency is high. Therefore, this device is expected to be used as a solid-state imaging device in the future. An example of a device of this type is disclosed in Japanese Laid-Open Patent Application No. 51-10715 (filed July 5, 1974 and published 28th January 1976). Figure 11 shows a construction explaining the principle of the device. Referring to this figure there is shown a horizontal scanning circuit 101 which turns "on" and "off" horizontal addressing switches 103, and a vertical scanning circuit 102 which turns "on" and "off" vertical addressing switches 104. Also shown are photoelectric element 105 which utilizes a photoconductive thin film, a supply voltage terminal 106 for driving the photoelectric elements 105, signal output lines 110-1, 110-2, and a resistor R. Figures 12 and 13 show the sectional structure of a photoelectric region in Figure 11 during manufacturing steps. The photoelectric region has a photoconductive thin film 105', a transparent electrode 106' and insulating films 108, 108' and 108''. The photoelectric region is mounted on a semiconductor substrate 111, and has a gate electrode 112, and an electrode 113 (of, for example, Al) which is in ohmic contact with one end 109 (diffused region formed from an impurity of a conductivity type opposite to that of the substrate 111) of the switch (indicated by numeral 104 in Fig. 11). When an optical image is focused by a lens onto the photoconductive thin film, the resistance of the photoconductive film varies according to the light intensity of the optical image. A voltage variation corresponding to the optical image appears at the end 109 of the vertical switch (indicated by numeral 104 in Fig. 11) and the variation appears as a video signal from an output terminal OUT through the signal output lines 110-1 and 110-2 shown in Figure 11. Also shown is an impurity diffused region 116 which has the same conductivity type as that of the region 109 and which is connected to the signal output line 110-1.

Since the fundamental structure of the present example is as shown in Figure 13, it will be described with reference thereto. The scanning circuit portion, including the switching circuits to be formed on the semiconductor substrate, was produced by the use of conventional manufacturing steps for semiconductor devices. A thin $SiO_2$ film of approximately 80 nm was formed on the p-type silicon substrate 111, and an $Si_3N_4$ film of approximately 140 nm was formed at a predetermined position on the $SiO_2$ film. The formation of the $SiO_2$ film was by conventional CVD process, and that of the $SiN_4$ film by the CVD process in which $Si_3N_4$ and $N_2$ were caused to flow. Subsequently, the silicon was locally oxidised in an atmosphere of $H_2:O_2=1:8$, to form the $SiO_2$ layer 108. This method is known as local oxidation of silicon for insulating elements, usually abbreviated to "LOCOS". The $Si_3N_4$ film and the $SiO_2$ film were removed, and the gate insulating film of a MOS transistor was formed by an $SiO_2$ film.

In the next step, the gate portion 112 of polycrystalline silicon and the diffused regions 109 and 116 were formed, and an $SiO_2$ film was formed thereon. An electrode lead-out opening for the impurity region 116 was provided in this $SiO_2$ film by etching. Aluminium, (Al) was evaporated to a thickness of 800 nm to form electrode 110-1. Also, an $SiO_2$ film 108' was formed with a thickness of 750 nm. Subsequently, an electrode lead-out opening was formed on the impurity region 109 by etching. 1 $\mu m$ of Al or Mo was evaporated to form an electrode 113. The electrode 113 was formed so that it covered the regions 109 and 116 and the gate portion. The reason for this is that the incidence of light on the signal processing region between the elements causes undesirable blooming.

It is optional to provide a recombination layer of $Sb_2S_3$ or the like on the electrode 113.

The manufacture of the foregoing semiconductor device portion can be satisfactorily achieved with the manufacturing process used to form a conventional MOS type integrated circuit.

The semiconductor body prepared by the steps thus far described was subsequently installed on a magnetron type sputtering apparatus. The atmosphere was a mixed gas consisting of Ar and hydrogen and being under 0.67 Pa ($5 \times 10^{-3}$ Torr). The hydrogen content was 60 pressure-%. The sputtering target was of silicon. The residual gas at the sputtering consisted of $1.3 \times 10^{-3}$ Pa ($1 \times 10^{-5}$ Torr) of oxygen, $1.3 \times 10^{-3}$ Pa ($1 \times 10^{-5}$ Torr) of nitrogen, and $6.7 \times 10^{-4}$ Pa ($5 \times 10^{-6}$ Torr) of water. By conducting the reactive sputtering at a frequency of 13.56 MHz and an input of 300 W, an amorphous silicon thin film 105' containing hydrogen was deposited on the semiconductor body to a thickness of 500 nm. The hydrogen content of the amorphous thin film was 15 atomic-%, and the resistivity was

9

$5 \times 10^{13} \, \Omega$ . cm. The optical forbidden band gap was 1.95 eV, and the ratio of (peak) 2,000/(peak) 2,100 was 0.5.

Very good lag and after-image characteristics were exhibited by the solid state imaging device as indicated in Example 1.

## Claims

1. A light sensitive screen including at least a light transmitting conductive film (2; 106') and at least one photoconductive layer (3; 7; 8; 105') formed of amorphous silicon containing at least 5 atomic-% and no more than 30 atomic-% of hydrogen, the light-transmitting conductive film being arranged with respect to the photo-conductive layer at the side of intended incidence of light; characterized in that said photoconductive layer has an optical forbidden band gap in the range 1.65 eV to 2.25 eV and infrared absorption spectrum in which the peak at the wave number 2,100 cm$^{-1}$ is not smaller than that at the wave number 2,000 cm$^{-1}$.

2. A screen according to claim 1, wherein a hole blocking layer (9) is interposed between the transparent conductive film (2) and said photoconductive layer (3).

3. A screen according to claim 1 or claim 2 wherein the transparent conductive film (2) is disposed on a light-transmitting substrate (1) and a beam landing layer (11) is disposed on a surface of said photoconductive layer (3) opposite to said transparent conductive film (2).

4. A screen according to claim 1 or claim 2 wherein said photoconductive layer (105') is disposed on a semiconductor substrate (111) which has scanning means (101, 102) etc. for sequentially selecting a plurality of photoelectric portions (105), said scanning means and said photoconductive layer being electronically coupled, and said light-transmitting conductive film (106') being disposed on said photoconductive layer (105').

5. A screen according to any one of the preceding claims, wherein the hydrogen-containing amorphous silicon layer is formed by a reactive sputtering process in an atmosphere containing hydrogen.

6. A screen according to any one of the preceding claims wherein said photoconductive layer formed of amorphous silicon containing hydrogen is one of a plurality of photoconductive layers.

7. A screen according to claim 6 wherein there is a plurality of said photoconductive layers (7, 8) of amorphous silicon containing hydrogen and fulfilling the requirements of claim 1 in respect of hydrogen percentage, optical forbidden band gap and infrared absorption spectrum.

8. A photoconductive type image pickup tube having a screen according to any one of the preceding claims.

9. A solid-state imaging device having a screen according to any one of the claims 1 to 7.

## Patentansprüche

1. Lichtempfindlicher Schrim mit mindestens einem lightdurchlässigen leitfähigen Film (2; 106') und mindestens einer photoleitfähigen Schicht (3; 7, 8; 105'), die aus mindestens 5 Atom-% und nicht mehr als 30 Atom-% Wasserstof enthantendem amorphen Silizium gebildet ist, wobei der lichtdurchlässige leitfähige Film bezüglich der photoleitfähigen Schicht auf der Seit des beabsichtigten Lichteinfalls angeordnet ist, dadurch gekennzeichnet, daß die photoleitfähige Schicht einen optischen Bandabstand im Bereich von 1,65 eV bis 2,25 eV und ein Infrarot-Absorptionsspektrum aufweist, in dem die Spitze bei der Wellenzahl 2100 cm$^{-1}$ nicht kleiner ist als die bei der Wellenzahl 2000 cm$^{-1}$.

2. Schirm nach Anspruch 1, wobei zwischen den transparenten leitfähigen Film (2) und die photoleitfähige Schicht (3) eine Löcher-Blockierschicht (9) eingefügt ist.

3. Schirm nach Anspruch 1 oder 2, wobei der transparente leitfähige Film (2) auf einem lichtdurchlässigen Substrat (1) angeordnet und auf einer von dem transparenten leitfähigen Film (2) abgewandten Oberfläche der photoleitfähigen Schicht (3) eine Strahl-Auffangschicht (11) angeordnet ist.

4. Schirm nach Anspruch 1 oder 2, wobei die photoleitfähige Schicht (105') auf einem Halbleitersubstrat (111) angeordnet ist, das eine Tasteinrichtung (101, 102) usw. zum sequentiellen Ansteuern einer Vielzahl von photoelektrischen Abschnitten (105) aufweist, wobei due Tasteinrichtung und die photoleitfähige Schicht elektronisch gekoppelt sind und der lichtdurchlässige leitfähige Film (106') auf der photoleitfähigen Schicht (105') angeordnet ist.

5. Schirm nach einem der vorhergehenden Ansprüche, wobei die Schicht aus wasserstoffhaltigem amorphen Silizium mittels eines Reaktiv-Sputtervorgangs in einer wasserstoffhaltigen Atmosphäre hergestellt ist.

6. Schirm nach einem der vorhergehenden Ansprüche, wobei die aus wasserstoffhaltigem amorphen Silizium gebildete photoleitfähige Schicht eine von mehreren photoleitfähigen Schichten ist.

7. Schirm nach Anspruch 6, wobei mehrere der photoleitfähigen Schichten (7, 8) aus amorphem Silizium vorhanden sind, das Wasserstoff enthält und die Bedingungen des Anspruchs 1 bezüglich Wasserstoffgehalt, optischem Bandabstand und Infrarot-Absorptionsspektrum erfüllt.

**0 039 219**

8. Bildaufnahmeröhre des photoleitfähigen Typs mit einen Schirm nach einem der vorhergehenden Ansprüche.

9. Festkörper-Bildaufnahmeeinrichtung mit einem Schirm nach einem der Ansprüche 1 bis 7.

## Revendications

1. Ecran photosensible comportant au moins une pellicule conductrice (2; 106') transmittant la lumière et au moins une couche photoconductrice (3; 7, 8; 105') constituée par du silicium amorphe contenant au moins 5% d'atomes et pas plus de 30% d'atomes d'hydrogène, la pellicule conductrice transmittant la lumière étant disposée par rapport à la couche photoconductrice sur le côté prévu d'incidence de la lumière, caractérisé en ce que ladite couche photoconductrice possède une bande interdite optique située dans la gamme entre 1,65 eV et 2,25 eV et un spectre d'absorption infrarouge, dans lequel le pic situé au niveau du chiffre d'onde de 2100 cm$^{-1}$ n'est pas inférieur à celui situé au niveau du chiffre d'onde de 2000 cm$^{-1}$.

2. Ecran selon la revendication 1, dans lequel une couche d'arrêt des trous (9) est interposée entre la pellicule transparente (2) et ladite couche photoconductrice (3).

3. Ecran selon la revendication 1 ou la revendication 2, dans lequel la pellicule conductrice transparente (2) est disposée sur un substrat (1) transmettant la lumière, est une couche (11) d'impact du faisceau est disposée sur une surface de ladite couche photoconductrice (3) à l'opposé de ladite pellicule conductrice transparente (2).

4. Ecran selon la revendication 1 ou la revendication 2, dans lequel ladite couche photoconductrice (105') est disposée sur un substrat semiconducteur (111) qui possède des moyens de balayage (101, 102) etc. pour réaliser la sélection séquentielle d'une pluralité de parties photoélectriques (105), lesdits moyens de balayage et ladite couche photoconductrice étant accouplés électroniquement, et ladite pellicule conductrice (106') transmettant la lumière étant disposée sur ladite couche photoconductrice (105').

5. Ecran selon l'une quelconque des revendications précédentes, dans lequel la couche de silicium amorphe contenant de l'hydrogéne est formée au moyen d'un processus de pulvérisation réactive dans une atmosphère contenant de l'hydrogène.

6. Ecran selon l'une quelconque des revendications précédentes dans lequel ladite couche photoconductrice est constituée par du silicium amorphe contenant de l'hydrogène est une couche faisant partie d'une pluralité de couches.

7. Ecran selon la revendication 6, dans lequel il est prévu une pluralité desdites couches photoconductrices (7, 8) constituées par du silicium amorphe contenant de l'hydrogène et satisfaisant aux exigences de la revendication 1 du point de vue du pourcentage d'hydrogène, de la bande interdite optique et du spectre d'absorption infrarouge.

8. Tube analyseur d'images du type photoconducteur comportant un écran selon l'une quelconque des revendications précédentes.

9. Dispositif de formation d'images à l'état solide comportant un écran selon l'une quelconque des revendications 1 à 7.

## FIG. 1

## FIG. 2

FIG. 3

FIG. 4

FIG. 5    FIG. 6

FIG. 7    FIG. 8

# FIG. 9

# FIG. 10

# FIG. 11

# FIG. 12

# FIG. 13